# EUROPEAN PATENT APPLICATION

(11) **EP 4 307 358 A1**
(43) Date of publication of application: **17.01.2024**
(21) Application number: 22766988.4
(22) Date of filing: 03.03.2022
(51) Int. Cl.: H01L 23/02, H01L 23/10

(54) **ELECTRONIC COMPONENT SEALING LID**

(30) Priority: 09.03.2021 JP 2021037523
(71) Applicant: Tomoegawa Co., Ltd., Tokyo 104-8335 (JP)
(72) Inventor: KOMAGATA Fumiki, Shizuoka-shi, Shizuoka 424-0831 (JP); ITOU Hiroshi, Shizuoka-shi, Shizuoka 424-0831 (JP); TOMIOKA Ayana, Shizuoka-shi, Shizuoka 424-0831 (JP)
(74) Representative: V.O.
(86) International application number: PCT/JP2022/009127
(87) International publication number: WO 2022/191030

(57) **Abstract**

The present invention provides an electronic component sealing lid which contains a liquid crystal polymer and suppresses detachment caused by reflow treatment. The electronic component sealing lid (10) according to the present invention includes a substrate that is formed from a liquid crystal polymer and includes a base section (11) and a wall section (12), and an inorganic substance (30) contained in the wall section (12), wherein the exposed area percentage for the inorganic substance (30) at a bonding surface (10a) of the wall section (12) is at least 5%.

## Description

### [Technical Field]

The present invention relates to an electronic component sealing lid.

Priority is claimed on Japanese Patent Application No. 2021-037523, filed March 9, 2021, the content of which is incorporated herein by reference.

### [Background Art]

Conventionally, radio frequency (RF) power devices (hereinafter referred to as "RF power devices") having chips mounted on a ceramic package obtained by laminating a copper heat sink and a ceramic substrate have used an airtight sealing lid to cover the semiconductor elements, the mounting surface of the substrate, and the space created by the resin framing and the like. A ceramic lid (having a cap shape) coated with an epoxy-based adhesive is typically used as this airtight sealing lid.

With the expansion of the RF power devices market due to the increase in 5G wireless base stations, the price of RF power devices has continued to fall. However, due to the oligopoly of ceramic package manufacturers, the ceramic packages that represent one of the structural components of RF power devices have not undergone significant cost reductions. Accordingly, the manufacturers of RF power devices have been investigating the use of plastic packages and plastic lids.

The plastics used for lids require reflow resistance. Accordingly, examples of the plastics used for lids include highly heat-resistant resins known as engineering plastics and super engineering plastics. For example, liquid crystal polymers (hereinafter abbreviated as "LCP") can be used as highly heat-resistant resins. For example, in Patent Document 1, an LCP is used as the resin that constitutes a lid for a semiconductor element mounting package. However, the LCP lid has low adhesiveness. As a result, the LCP lid suffers from detachment of the lid from the package body following the reflow treatment conducted during production of the semiconductor element mounting package.

Accordingly, in Patent Document 2, in order to improve the adhesiveness of LCP lids, the surface of the LCP lid is subjected to a sandblasting treatment or the like. Subjecting the surface of the lid to a sandblasting treatment or the like to increase the surface roughness of the lid surface aims to provide an anchoring effect on the lid surface.

### [Citation List]

### [Patent Documents]

[Patent Document 1]
   Japanese Unexamined Patent Application, First Publication No. 2016-76669
[Patent Document 2]
   Japanese Unexamined Patent Application, First Publication No. Hei 01-236246

### [Summary of the Invention]

### [Problems to be Solved by the Invention]

However, Patent Document 2 only discloses the conducting of a sandblasting treatment or the like to improve the adhesiveness of an LCP lid. In other words, Patent Document 2 made no investigation of the degree of sandblasting treatment required to impart a satisfactory level of adhesiveness to the LCP lid.

The present invention has been developed in light of the above circumstances, and has an object of providing an electronic component sealing lid which contains a liquid crystal polymer and suppresses detachment caused by reflow treatment.

### [Means for Solving the Problems]

The present invention has the following aspects.
[1] An electronic component sealing lid including a substrate formed from a liquid crystal polymer, and an inorganic substance contained in the substrate, wherein the exposed area percentage for the inorganic substance at a bonding surface of the substrate is at least 5%.
[2] The electronic component sealing lid according to [1], wherein the amount of the inorganic substance is at least 10 parts by mass but not more than 60 parts by mass per 100 parts by mass of the liquid crystal polymer.
[3] The electronic component sealing lid according to [1] or [2], wherein an adhesive layer is laminated onto the bonding surface, and the adhesive layer contains a thermosetting resin and a curing agent.
[4] The electronic component sealing lid according to [3], wherein the adhesive layer contains a silane coupling agent.
[5] The electronic component sealing lid according to [3] or [4], wherein the amount of the thermosetting resin is at least 1% by mass but not more than 80% by mass of the total mass of the adhesive layer.
[6] The electronic component sealing lid according to any one of [3] to [5], wherein the content ratio of the curing agent relative to the thermosetting resin, expressed as an equivalence ratio, is at least 0.2 but not more than 1.

### [Effects of the Invention]

The present invention is able to provide an electronic component sealing lid which contains a liquid crystal polymer and suppresses detachment caused by reflow treatment.

### [Brief Description of Drawings]

FIG. 1A is a plan view of a schematic outline illustrating the electronic component sealing lid according to an embodiment of the present invention.
FIG. 1B is a schematic outline illustrating the electronic component sealing lid according to an embodiment of the present invention, and represents a cross-sectional view along the line A-A of FIG. 1A.
FIG. 2 is a schematic cross-sectional view illustrating the electronic component sealing lid according to an embodiment of the present invention.
FIG. 3 is an SEM image of the lap polished surface of the electronic component sealing lid (lid a) of Test Example 1.
FIG. 4 is an SEM image of the lap polished surface of the electronic component sealing lid (lid b) of Test Example 2.

### [Description of Embodiments]

Embodiments of the electronic component sealing lid according to the present invention are described below with reference to the drawings. It should be noted that the drawings used in the following description may sometimes be drawn with characteristic portions enlarged as appropriate, and the dimensional ratios and the like between the constituent elements may differ from the actual values. Further, the materials and dimensions and the like presented in the following description are merely examples, which in no way limit the present invention, and may be altered as appropriate within the scope of the present invention.

### [Electronic Component Sealing Lid]

The electronic component sealing lid according to one embodiment of the present invention includes a substrate formed from a liquid crystal polymer, and an inorganic substance contained in the substrate, wherein the exposed area percentage for the inorganic substance at a bonding surface of the substrate is at least 5%.

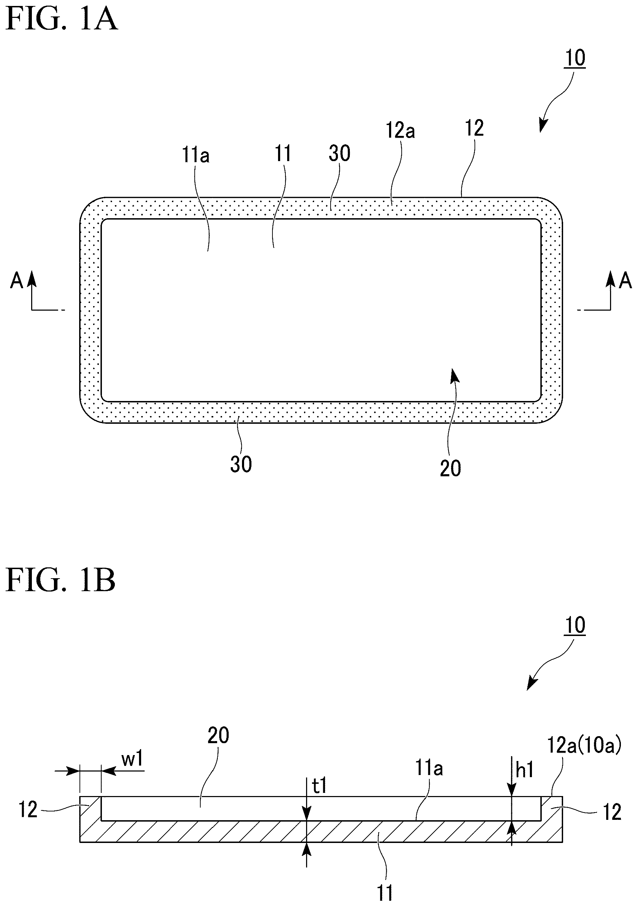

The electronic component sealing lid of the present embodiment is described below with reference to FIG. 1A and FIG. 1B.

FIG. 1A and FIG. 1B are a pair of schematic outlines illustrating the electronic component sealing lid according to the present embodiment, wherein FIG. 1A is a plan view and FIG. 1B is a cross-sectional view along the line A-A of FIG. 1A.

The electronic component sealing lid 10 illustrated in FIG. 1A and FIG. 1B is formed from a resin composition containing a liquid crystal polymer and an inorganic substance.

The electronic component sealing lid 10 of the present embodiment includes a substrate having a base section 11 and a wall section 12. The base section 11 is a rectangular sheet-like region when viewed in plain view. The wall section 12 is a protruding region which protrudes in the thickness direction of the base section 11 from one surface 11a of the base section 11. Further, the wall section 12 functions as the edge of the base section 11 on the one surface side 11a of the base section 11. The electronic component sealing lid 10 has a space 20 surrounded by the base section 11 and the wall section 12. An electronic component such as a semiconductor chip is accommodated within this space 20. The surface (the upper surface in FIG. 1A and FIG. 1B) 12a of the wall section 12 on the opposite side to the surface 11a of the base section 11 functions as the bonding surface 10a of the electronic component sealing lid 10. The bonding surface 10a of the electronic component sealing lid 10 is the surface that is adhered to the main body of the electronic component package in order to enable the electronic component sealing lid 10 to seal the electronic component, and is the surface on which an adhesive layer is provided.

There are no particular limitations on the thickness t1 of the base section 11. There are no particular limitations on the height h1 of the wall section 12 from the surface 11a of the base section 11. There are no particular limitations on the width w1 of the wall section 12.

In the electronic component sealing lid 10 of the present embodiment, at the bonding surface (the upper surface) 10a (the upper surface (bonding surface) 12a of the electronic component sealing lid 10), the exposed area percentage for an inorganic substance 30 is at least 5%, and is preferably at least 7%, and more preferably 9% or higher. If the exposed area percentage for the inorganic substance 30 is less than 5%, then the adhesiveness at the bonding surface 10a is unsatisfactory, and the electronic component sealing lid 10 tends to detach from the main body of the electronic component package during reflow durability testing.

The exposed area percentage for the inorganic substance 30 at the bonding surface 10a refers to the area of exposed inorganic substance 30 at the bonding surface 10a relative to a value of 100% for the total area of the bonding surface 10a including the exposed inorganic substance 30.

The exposed area percentage for the inorganic substance 30 at the bonding surface 10a can be measured by coating the bonding surface 10a with carbon, platinum or gold as a pretreatment, analyzing the surface using a scanning electron microscope, subjecting the obtained scanning electron microscope image to binarization processing using image analysis software such as WINROF, and then determining the respective area percentages for the inorganic substance component and the resin component.

### [Liquid Crystal Polymer]

In the electronic component sealing lid 10 of the present embodiment, the liquid crystal polymer is preferably a polyester known as a thermotropic liquid crystal polymer.

Polycondensates of ethylene terephthalate and para-hydroxybenzoic acid, represented by formula (1) shown below, are preferred as the liquid crystal polymer. Specific examples of liquid crystal polymers represented by formula (1) include SIVERIS (a brand name) manufactured by Toray Industries, Inc.

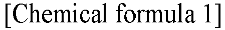

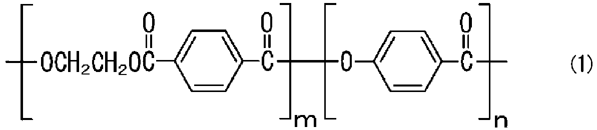

Polycondensates of phenol, phthalic acid and para-hydroxybenzoic acid (a polycondensate of 4,4-dihydroxybiphenol and terephthalic acid), represented by formula (2) shown below, are also preferred as the liquid crystal polymer. Specific examples of liquid crystal polymers represented by formula (2) include SUMIKASUPER (a brand name) manufactured by Sumitomo Chemical Co., Ltd., and XYDAR (a brand name) manufactured by ENEOS Corporation.

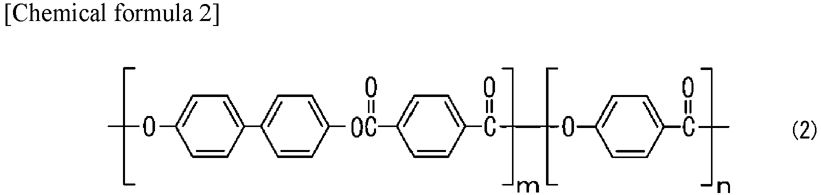

Polycondensates of 2,6-hydroxynaphthoic acid and para-hydroxybenzoic acid, represented by formula (3) shown below, are also preferred as the liquid crystal polymer. Specific examples of liquid crystal polymers represented by formula (3) include LAPEROS (a brand name) manufactured by Polyplastics Corporation.

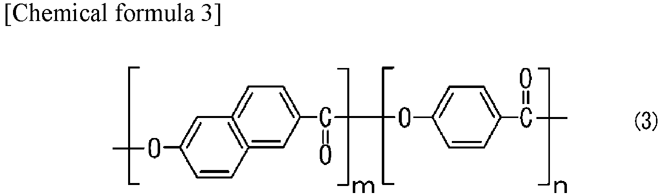

### [Inorganic Substance]

Examples of the inorganic substance 30 include talc, mica, clay, sericite, calcium carbonate, calcium silicate, silica, alumina, aluminum hydroxide, magnesium hydroxide, graphite, glass fiber, and carbon fiber.

In the electronic component sealing lid 10 of the present embodiment, the amount of the inorganic filler 30, per 100 parts by mass of the liquid crystal polymer, is preferably at least 10 parts by mass but not more than 60 parts by mass, and more preferably at least 20 parts by mass, but not more than 50 parts by mass. If the amount of the inorganic filler 30 is less than the above lower limit, then a deterioration in the anisotropy suppression effect of the molded body may result in worse warping or a decrease in weld strength. If the amount of the inorganic filler 30 exceeds the above upper limit, then the fluidity during the molded body molding step tends to deteriorate.

The average particle size of the inorganic filler 30 is preferably at least 1 µm but not more than 50 µm, and more preferably at least 5 µm but not more than 20 µm. Provided the average particle size of the inorganic filler 30 falls within this range, the adhesiveness at the bonding surface 10a of the electronic component sealing lid 10 can be further improved in those cases where the exposed area percentage for the inorganic substance 30 is at least 5%.

The average particle size of the inorganic filler 30 can be measured by performing a scanning electron microscope analysis of a cross-section of the molded body, and then conducting image analysis of the obtained scanning electron microscope image.

### [Other Components]

In the electronic component sealing lid 10 of the present embodiment, the substrate 11 may, if necessary, also contain various additives such as antistatic agents, heat stabilizers, light stabilizers, flame retardants, lubricants, inorganic colorants, organic colorants, surface smoothing agents, surface gloss improvers, and mold release improvers such as fluororesins.

In the electronic component sealing lid 10 of the present embodiment, because the exposed area percentage for the inorganic substance 30 at the bonding surface 10a is at least 5%, the adhesiveness at the bonding surface 10a is excellent, and detachment from the main body of the electronic component package as a result of reflow treatment can be suppressed.

### [Method for Producing Electronic Component Sealing Lid]

A method for producing an electronic component sealing lid according to one embodiment of the present invention includes a preformed body molding step of molding a preformed body containing the liquid crystal polymer and the inorganic substance, a molded body molding step of subjecting the preformed body to pressurized heating to obtain a molded body, and a polishing step of polishing a surface (that becomes the bonding surface) of the molded body to expose the inorganic substance.

### [Preformed Body Molding Step]

In the preformed body molding step, the resin composition containing a powder of the liquid crystal polymer and the inorganic substance is placed in a mold having a prescribed shape and volume, and is then compressed by cold pressing to mold a preformed body.

In the preformed body molding step, an amount of the liquid crystal polymer calculated from the volume of the mold, the specific gravity of the liquid crystal polymer and the bulk density of the liquid crystal polymer is placed in the mold, and that liquid crystal polymer is compressed by cold pressing to mold a preformed body.

### [Molded Body Molding Step]

In the molded body molding step, the preformed body obtained in the preformed body molding step is heated and pressurized to obtain a molded body.

In the molded body molding step, the preformed body is removed from the mold and placed in a separate mold, or the mold used in the production step for the preformed body is simply reused, and either a compression plate (metal plate) is used to cover the upper surface of the mold or an inner lid is formed with a metal plate, and subsequently, a compression molding apparatus is then used to heat and pressurize the preformed body to obtain a molded body containing the aforementioned substrate 11 and the inorganic substance 30. The obtained molded body is cooled to room temperature and then removed from the mold.

### [Polishing Step]

In the polishing step, the surface of the molded body (the surface that becomes the bonding surface 10a) is polished to expose the inorganic substance.

When the liquid crystal polymer is molded in the mold, a thin layer (skin layer) in which the liquid crystal polymer is aligned along the surface of the mold is formed on the surfaces of the molded body that contact the mold. The thickness of this skin layer is about 1 µm to 2 µm. Accordingly, in the polishing step, by removing at least 2 µm from the surface of the molded body, the skin layer can be removed, exposing the inorganic substance at the surface of the molded body. The degree of polishing of the molded body surface (the amount of polishing in the thickness direction of the molded body) is adjusted so that the exposed area percentage of the inorganic substance at the surface of the molded body (the surface that becomes the bonding surface 10a) reaches at least 5%.

If the adhesive layer is formed on the surface of the molded body and the molded body is then bonded to a bonding target object with the skin layer still in existence, then the skin layer may detach from the molded body, causing the molded body to peel away from the bonding target object.

There are no particular limitations on the polishing method used in the polishing step, and examples include lap polishing, whetstone polishing, blast polishing, buff polishing, and grinding.

By conducting the above steps, the electronic component sealing lid 10 of the present embodiment can be obtained.

### <Other Embodiments>

The present invention is not limited to the embodiment described above.

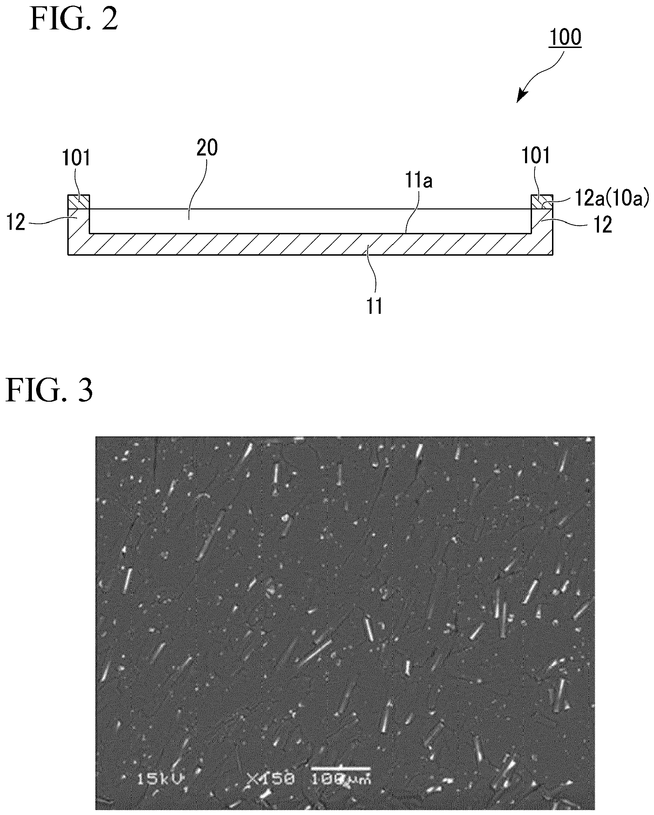

For example, an electronic component sealing lid 100 according to a modification such as that illustrated in FIG. 2 may be employed. In the electronic component sealing lid 100 according to this modification, portions that represent the same structural elements as in the embodiment described above are labeled with the same reference symbols, and description of those portions is omitted, with only the points of difference being described below.

The electronic component sealing lid 100 according to the modification illustrated in FIG. 2 includes the electronic component sealing lid 10 of the embodiment described above, and an adhesive layer 101. In other words, the electronic component sealing lid 100 includes the electronic component sealing lid 10, and the adhesive layer 101 that is laminated to the upper surface (the bonding surface) 10a of the electronic component sealing lid 10.

The adhesive layer 101 contains a thermosetting resin and a curing agent. In other words, the adhesive layer 101 is formed from an adhesive containing the thermosetting resin and the curing agent.

The thickness of the adhesive layer 101 is preferably at least 30 µm but not more than 300 µm, and more preferably at least 50 µm but not more than 200 µm. If the thickness of the adhesive layer 101 is less than the above lower limit, then the amount of the adhesive tends to be insufficient to spread adequately across the bonding surface, which may cause a deterioration in the adhesive strength or unsatisfactory airtightness. If the thickness of the adhesive layer 101 exceeds the above upper limit, then internal pressure increases caused by volume shrinkage and temperature increase during pressure bonding at the time of sealing tend to result in the formation of air passages that cause leakage from the interior of the bonding surface, meaning airtightness cannot be ensured.

### [Thermosetting Resin]

Examples of the thermosetting resin include phenol resins, furan resins, epoxy resins, unsaturated polyester resins, polyimide resins, urea resins and melamine resins. Among these, in terms of the heat resistance, adhesive strength, airtightness, dimensional stability and chemical resistance, epoxy resins are particularly desirable.

The epoxy resin is, for example, preferably at least one type of liquid epoxy resin selected from the group consisting of bisphenol A diglycidyl ether, bisphenol F diglycidyl ether, hydrogenated bisphenol A diglycidyl ether, and glycidylamine. Among the various epoxy resins, in terms of the ease of coating onto the main body of the electronic component package and the electronic component sealing lid, resins that are liquid at room temperature are preferred. However, even epoxy resins that are solid at room temperature can be used, for example, by mixing with a liquid epoxy resin or by adding a reactive diluent.

Further, epoxy resins that are solid at room temperature may also be used by increasing the temperature during coating, thereby lowering the viscosity of the resin. Moreover, epoxy resins that are solid at room temperature may also be used by dispersion in a liquid curing agent or reactive diluent.

The amount of the thermosetting resin, relative to the total mass of the adhesive layer 101, is preferably at least 30% by mass but not more than 80% by mass, and more preferably at least 50% by mass but not more than 80% by mass. Provided the amount of the thermosetting resin is at least 30% by mass, satisfactory heat resistance can be achieved for the adhesive layer 101. Provided the amount of the thermosetting resin is not more than 80% by mass, problems such as increases in the internal stress of the adhesive layer 101, increased brittleness of the adhesive layer 101, causing a deterioration in the heat resistance reliability, and worsening of the workability associated with forming the adhesive layer 101 can be better suppressed. Further, if the amount of the thermosetting resin is at least 50% by mass but not more than 80% by mass, then an adhesive layer 101 having comparatively low internal stress and a high glass transition temperature can be formed, meaning an electronic component sealing lid 100 having excellent heat resistance reliability can be obtained.

### [Curing Agent]

In the electronic component sealing lid 100 of the present embodiment, the adhesive layer 101 contains a curing agent. The curing agent is preferably an aromatic amine such as diaminodiphenylmethane or diaminodiphenylsulfone, or an alicyclic amine.

The content ratio of the curing agent relative to the thermosetting resin, expressed as an equivalence ratio, is preferably at least 0.2 but not more than 1, and more preferably at least 0.2 but not more than 0.7. Provided the content ratio of the curing agent satisfies this range, the heat resistance of the adhesive layer 101 and the workability associated with forming the adhesive layer 101 both improve.

### [Other Components]

The adhesive layer 101 may also contain a stabilizer.

For the stabilizer, either a borate ester may be used alone, or a combination of a borate ester and a phenol resin may be used. The borate ester is either an alkyl ester of boric acid or an aryl ester of boric acid. Specific examples of the borate ester include trimethyl borate, triethyl borate, tributyl borate, and triphenyl borate.

In the electronic component sealing lid 100 of the present embodiment, the amount of the borate ester is preferably at least 5 parts by mass but not more than 15 parts by mass, per 100 parts by mass of the thermosetting resin. Provided the amount of the borate ester is at least as large as the above lower limit, a storage stability improvement effect can be achieved for the adhesive layer 101. Provided the amount of the borate ester is not more than the above upper limit, there is no reduction in the curing reactivity of the adhesive layer 101.

The adhesive layer 101 preferably also contains an elastomer for the purposes of improving the adhesion and bonding with the main body of the electronic component package, and moderating any stress that develops between the electronic component sealing lid 100 and the above main body during bonding.

There are no particular limitations on the elastomer, and examples include rubbers and thermoplastic elastomers (hereinafter abbreviated as "TPE"). Specific examples of the rubbers include isoprene rubber, butadiene rubber, styrene-butadiene rubber, chloroprene rubber, nitrile rubber, butyl rubber, ethylene-propylene rubber, acrylic rubber, silicone rubber, fluororubber, urethane rubber and polysulfide rubber. Examples of the TPE include styrene-based TPE, olefin-based TPE, urethane-based TPE, ester-based TPE, amide-based TPE, natural rubber-based TPE, and polyvinyl chloride (PVC)-based TPE. One of these elastomers may be used alone, or a combination of two or more elastomers may be used.

In the electronic component sealing lid 100 of the present embodiment, the amount of the elastomer is preferably at least 5 parts by mass but not more than 15 parts by mass, per 100 parts by mass of the thermosetting resin. Provided the amount of the elastomer is at least the above lower limit, a storage stability improvement effect can be achieved for the adhesive layer 101. Provided the amount of the elastomer is not more than the above upper limit, there is no reduction in the curing reactivity of the adhesive layer 101.

The adhesive layer 101 may also contain a reactive diluent, reaction accelerator, filler, or silane coupling agent or the like.

Any substance may be used as the reactive diluent, provided it is capable of adjusting the viscosity of the adhesive that constitutes the adhesive layer 101, but does not gasify during sealing of the main body of the electronic component package, and therefore does not affect the characteristics of the housed electronic component.

A reaction accelerator is used in those cases where the adhesive layer 101 requires curing in a short period of time under high temperature conditions. Examples of the reaction accelerator include imidazoles such as 2-ethyl-4-methylimidazole and 2-undecylimidazole, amines such as m-phenylenediamine, diaminodiphenyl ether and boron trifluoride monoethylamine complex, as well as triphenylphosphines and carboxylic acids.

Examples of the filler include silica, quartz powder, alumina, calcium carbonate, magnesium oxide, and zinc oxide.

Examples of the organic reactive group of the silane coupling agent include a vinyl group, alicyclic epoxy group, glycidyl group, methacrylic group, acrylic group, styryl group, amino group, diamino group, mercapto group, ureido group, and isocyanate group. Among the various silane coupling agents, a silane coupling agent having a glycidyl group is preferred.

In the electronic component sealing lid 100 of the present embodiment, the adhesive that constitutes the adhesive layer 101 is preferably liquid at room temperature. The viscosity at 25°C of the adhesive that constitutes the adhesive layer 101 is preferably at least 0.001 Pa s but not more than 1,000 Pa s. However, adhesives that are solid at room temperature but become liquid upon heating can also be used in the present embodiment.

The adhesive layer 101 in the electronic component sealing lid 100 of the present embodiment is obtained by applying the adhesive described above in a semi-cured state to form an arbitrary shape on the upper surface 10a of the electronic component sealing lid 10. Here, the term "semi-cured state" refers to a state also called a B-stage state. This state describes a state in which two-dimensional reactions have progressed between the thermosetting resin and the curing agent in the semi-cured stage, resulting in the existence of linear polymer chains. The adhesive layer 101 in this state has the characteristics of the thermosetting resin, while also having the characteristics of a thermoplastic resin, meaning it melts upon heating, and undergoes reaction with a separate curing agent above a certain temperature, resulting in the progression of three-dimensional crosslinking reactions that yield an insoluble and infusible cured product.

Examples of the method used for forming the adhesive layer 101 on the upper surface 10a of the electronic component sealing lid 10 include screen printing methods and dispensing methods. However, the method for forming the adhesive layer 101 is not limited to these methods, and any method that enables control of the dimensional precision and coating shape may be used.

The electronic component sealing lid of the present invention may have a sheet-like shape having only the base section 11 and lacking the wall section 12. In the case of a sheet-like electronic component sealing lid, the exposed area percentage of the inorganic substance at the bonding surface in a specified location on which the adhesive layer is provided must be at least 5%.

### [Examples]

The present invention is described below in further detail using a series of test examples, but the present invention is not limited to the following test examples.

### [Test Examples]

### (Electronic Component Sealing Lids)

A resin composition containing 100 parts by mass of the liquid crystal polymer a represented by formula (1) above and 40 parts by mass of glass fiber was placed in a mold and compressed by cold pressing to mold a preformed body.

Subsequently, the preformed body was heated to a temperature of 360°C and injected into a mold under an injection pressure of 130 MPa, and then cooled and held for 15 seconds to obtain a molded body of length 6.34 mm × width 6.24 mm × thickness 1.5 mm (cavity dimensions: length 5.34 mm × width 5.24 mm × depth 1.0 mm).

Next, the surface of the molded body that was to become the bonding surface was subjected to lap polishing as shown in Table 1, thus obtaining a series of electronic component sealing lids (lid a to lid g). The amount of lap polishing shown in Table 1 describes the length (depth) removed from the surface that becomes the bonding surface of the molded body.

Subsequently, the lap polished surface of each electronic component sealing lid was inspected using a scanning electron microscope (SEM, product name: JSM-6460LV, manufactured by JEOL Ltd.), thus obtaining an SEM image of that surface.

Following binarization of the obtained SEM image, the exposed area percentage of glass fiber at the lap polished surface of the electronic component sealing lid was calculated. The results are shown in Table 1.

In the SEM image of the lap polished surface of each electronic component sealing lid, the glass fiber appeared white and the liquid crystal polymer appeared black, making binarization processing possible.

**[Table 1]**

| | Lid | Amount of lap polishing [µm] | Exposed area percentage of glass fiber [%] |
|---|---|---|---|
| Test Example 1 | Lid a | Unpolished | 3 |
| Test Example 2 | Lid b | 2 | 9 |
| Test Example 3 | Lid c | 5 | 8 |
| Test Example 4 | Lid d | 8 | 5 |
| Test Example 5 | Lid e | 10 | 7 |
| Test Example 6 | Lid f | 20 | 9 |
| Test Example 7 | Lid g | 40 | 10 |

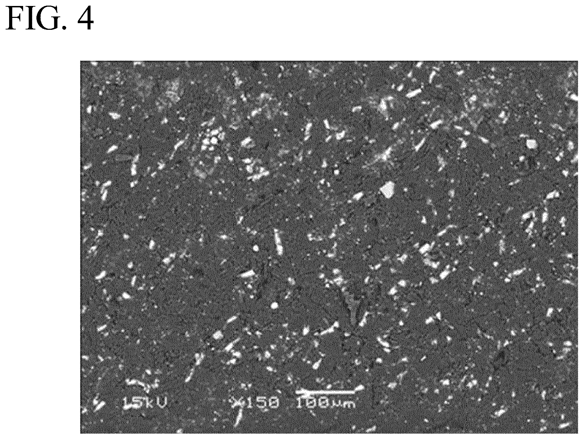

The SEM image of the lap polished surface of the electronic component sealing lid (lid a) of Test Example 1 is shown in FIG. 3. The SEM image of the lap polished surface of the electronic component sealing lid (lid b) of Test Example 2 is shown in FIG. 4.

### (Adhesives)

### <Adhesive A>

The materials listed below were kneaded using a three-roll mill, and the kneaded product was then subjected to vacuum degassing to obtain an adhesive A.
Thermosetting resin (bisphenol A epoxy resin) 100 parts by mass
Curing agent (diaminodiphenylmethane) 9.3 parts by mass
Stabilizer (epoxyphenol borate ester mixture) 10 parts by mass
Reaction accelerator (2,4-diamino-6-[2'-methylimadazolyl-(1')]-ethyl-S-triazine isocyanuric acid adduct) 2.5 parts by mass
Silane coupling agent (3-glycidoxypropyltrimethoxysilane) 1 part by mass
Elastomer (polyisoprene maleic anhydride adduct) 15 parts by mass
Filler (silica) 10 parts by mass

### <Adhesive B>

With the exception of removing the silane coupling agent from the materials listed above for the adhesive A, an adhesive B was obtained in the same manner as the adhesive A.

### (Evaluations)

The adhesive A was applied to the edge portions of the lids a to g obtained in Test Examples 1 to 7 in sufficient amount to form a width of 0.5 mm, and the adhesive A was then heated and dried to form a semi-cured state, thus yielding electronic component sealing lids of Test Example 8 to Test Example 14, each having an adhesive layer composed of the adhesive A.

Each lid was mounted on a copper sheet, and the resulting structure was heated at 90°C for one hour while a 2 kg load was applied, thus completely curing the adhesive layer.

Further, the adhesive B was also applied to the edge portions of the lids a to g obtained in Test Examples 1 to 7 in sufficient amount to form a width of 0.5 mm, and the adhesive B was then heated and dried to form a semi-cured state, thus yielding electronic component sealing lids of Test Example 15 to Test Example 21, each having an adhesive layer composed of the adhesive B.

Each of these lids was mounted on a copper sheet, and the resulting structure was heated at 90°C for one hour while a 2 kg load was applied, thus completely curing the adhesive layer.

Each of the lids bonded to a copper sheet obtained in the manner described above was subjected to the tests described below. The results are shown in Table 2.

### (1) Adhesive Strength Test

The copper sheet was secured, claws were hooked onto the lid, a pulling load (shearing) was applied in the horizontal direction at a pull speed of 50 mm/minute, and the state of the lid was observed. If the lid had undergone absolutely no detachment from the copper sheet, an evaluation of "A" was recorded, if the lid had partially detached from the copper sheet, an evaluation of "B" was recorded, and if the lid had detached completely from the copper sheet, an evaluation of "C" was recorded.

### (2) Reflow Test

Each of the lids bonded to a copper sheet was subjected to three repetitions of retention for 30 seconds in a reflow tank at a temperature of 260°C, and the state of the lid was then inspected. If the lid had undergone absolutely no detachment from the copper sheet, an evaluation of "A" was recorded, if the lid had partially detached from the copper sheet, an evaluation of "B" was recorded, and if the lid had detached completely from the copper sheet, an evaluation of "C" was recorded.

### (3) High-Temperature High-Humidity Test

Each of the lids bonded to a copper sheet was left to stand for 1,000 hours in a tank at a temperature of 85°C and a humidity of 85%, and the state of the lid was then inspected. If the lid had undergone absolutely no detachment from the copper sheet, an evaluation of "A" was recorded, if the lid had partially detached from the copper sheet, an evaluation of "B" was recorded, and if the lid had detached completely from the copper sheet, an evaluation of "C" was recorded.

**[Table 2]**

| | Lid | Adhesive | | Adhesive strength test | Reflow test | High-temperature high-humidity test |
|---|---|---|---|---|---|---|
| Test Example 8 | Lid a | Adhesive A | - | C | C | c |
| Test Example 9 | Lid b | | | A | A | A |
| Test Example 10 | Lid c | | | A | A | A |
| Test Example 11 | Lid d | | | A | A | A |
| Test Example 12 | Lid e | | | A | A | A |
| Test Example 13 | Lid f | | | A | A | A |
| Test Example 14 | Lid g | | | A | A | A |
| Test Example 15 | Lid a | - | Adhesive B | C | C | C |
| Test Example 16 | Lid b | | | B | B | B |
| Test Example 17 | Lid c | | | B | B | B |
| Test Example 18 | Lid d | | | B | B | B |
| Test Example 19 | Lid e | | | B | B | B |
| Test Example 20 | Lid f | | | B | B | B |
| Test Example 21 | Lid g | | | B | B | B |

Based on the results in Table 2, it was evident that the lids for which the exposed area percentage of glass fiber at the lap polished surface was at least 5% yielded favorable results, with no detachment in the adhesive strength test, the reflow test or the high-temperature high-humidity test.

In contrast, the lids for which the exposed area percentage of glass fiber at the lap polished surface was less than 5% suffered from detachment in the adhesive strength test, the reflow test and the high-temperature high-humidity test.

Further, the lids that used the adhesive A containing the silane coupling agent yielded more favorable results than the lids that used the adhesive B that did not contain the silane coupling agent, with no detachment in the adhesive strength test, the reflow test or the high-temperature high-humidity test.

### [Industrial Applicability]

The electronic component sealing lid of the present invention contains a liquid crystal polymer, and yet exhibits improved adhesiveness with the adhesive at the bonding surface with the main body of an electronic component package, and suppresses detachment from the main body of the electronic component package caused by reflow treatment. As a result, the electronic component sealing lid of the present invention can be used favorably in electronic component packages for sealing the electronic component.

### [Reference Signs List]

- 10, 100:: Electronic component sealing lid
- 11:: Base section
- 12:: Wall section
- 30:: Inorganic substance
- 101:: Adhesive layer

## Claims

1. An electronic component sealing lid comprising a substrate formed from a liquid crystal polymer, and an inorganic substance contained in the substrate, wherein
an exposed area percentage for the inorganic substance at a bonding surface of the substrate is at least 5%.

2. The electronic component sealing lid according to Claim 1, wherein an amount of the inorganic substance is at least 10 parts by mass but not more than 60 parts by mass per 100 parts by mass of the liquid crystal polymer.

3. The electronic component sealing lid according to Claim 1 or 2, wherein an adhesive layer is laminated onto the bonding surface, and
the adhesive layer comprises a thermosetting resin and a curing agent.

4. The electronic component sealing lid according to Claim 3, wherein the adhesive layer comprises a silane coupling agent.

5. The electronic component sealing lid according to Claim 3 or 4, wherein an amount of the thermosetting resin is at least 1% by mass but not more than 80% by mass of a total mass of the adhesive layer.

6. The electronic component sealing lid according to any one of Claims 3 to 5, wherein a content ratio of the curing agent relative to the thermosetting resin, expressed as an equivalence ratio, is at least 0.2 but not more than 1.
